# EUROPÄISCHE PATENTSCHRIFT

(11) **EP 2 449 586 B1**
(45) Veröffentlichungstag und Bekanntmachung des Hinweises auf die Patenterteilung: **21.10.2020**
(21) Anmeldenummer: 10744841.7
(22) Anmeldetag: 29.06.2010
(51) Int. Cl.: H01L 23/373

(54) **ELEKTRONISCHE VORRICHTUNG**
ELECTRONIC DEVICE
DISPOSITIF ÉLECTRONIQUE

(30) Priorität: 02.07.2009 DE 102009033029
(43) Veröffentlichungstag der Anmeldung: 09.05.2012
(73) Patentinhaber: Rogers Germany GmbH, 92676 Eschenbach (DE)
(72) Erfinder: SCHULZ-HARDER, Jürgen, 91207 Lauf (DE); MEYER, Andreas, 93173 Wenzenbach (DE)
(74) Vertreter: Müller Schupfner & Partner Patent- und Rechtsanwaltspartnerschaft mbB
(86) Internationale Anmeldenummer: PCT/DE2010/000745
(87) Internationale Veröffentlichungsnummer: WO 2011/000360

(56) Entgegenhaltungen:
- DE-A1-102007 014 433
- DE-C1- 3 922 485
- DE-T2- 69 730 388
- JP-A- H09 283 703
- US-A- 5 362 926
- US-A- 5 672 848
- US-A1- 2006 258 055
- US-A1- 2007 128 772
- US-B1- 6 261 703
- D.M. Su: "SPEC NO: DSAA9073", , 16 April 2009 (2009-04-16), XP55628470, Retrieved from the Internet: URL:http://www.farnell.com/datasheets/5130 04.pdf [retrieved on 2019-10-03]

## Beschreibung

Die Erfindung bezieht sich auf elektronische Vorrichtungen bzw. auf elektronische Schaltkreise und/oder ein Module gemäß Oberbegriff Patentanspruch 1.

Elektronische Vorrichtungen oder Schaltkreise bzw. Module diese Art sind in zahlreichen Ausführungen bekannt.

Bekannt ist ferner das sogenannten "DCB-Verfahrens" (Direct-Copper-Bond-Technology) beispielsweise zum Verbinden von Metallschichten oder -blechen (z.B. Kupferblechen oder -folien) mit einander und/oder mit Keramik oder Keramikschichten, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 3744 120 oder in der DE- PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Dieses DCB-Verfahren weist dann z.B. folgende Verfahrensschritte auf:
> Oxidieren einer Kupferfolie derart, dass sich eine gleichmäßige Kupferoxidschicht ergibt;
> Auflegen des Kupferfolie auf die Keramikschicht;
> Erhitzen des Verbundes auf eine Prozeßtemperatur zwischen etwa 1025 bis 1083°C, z.B. auf ca. 1071 °C;
> Abkühlen auf Raumtemperatur.

Bekannt ist weiterhin das sogenannte Aktivlot-Verfahren (DE 22 13 1 15; EP-A-153 618) z.B. zum Verbinden von Metallisierungen bildenden Metallschichten oder Metallfolien, insbesondere auch von Kupferschichten oder Kupferfolien mit Keramikmaterial. Bei diesem Verfahren, welches speziell auch zum Herstellen von Metall-Keramik-Substraten verwendet wird, wird bei einer Temperatur zwischen ca. 800 - 1000 °C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlot-Verbindung ist.

Aus der US 6,261,703 B1 ist ein Kupfer-Keramik-Substrat bekannt, wobei eine Zwischenschicht zwischen dem Keramikträger und einer Kupferlage angeordnet ist. Dabei steht die Zwischenlage abschnittsweise gegenüber der Zwischenlage vor.

In der US 2006 0 258 055 A1 wird eine Wärmspreizung, verursacht von einem elektrischen Bauteil auf einer Metallschicht einer Leiterplatte, thematisiert.

Die DE 697 30 388 T2 beschreibt eine Leiterplatte mit einem dreistufigen Aufbau der Metallisierung.

Die JP 9 283 703 offenbart ein Metall-Keramik-Substrat mit einer Metallisierung, die einen gestuften Verlauf aufweist.

Aufgabe der Erfindung ist es, elektronische Vorrichtungen aufzuzeigen, die hinsichtlich der Kühlung von Leistungsbauelementen, d.h. von Bauelementen, die im Betrieb auch eine erhebliche Verlustleistung und damit hohe Wärme erzeugen, optimiert sind. Zur Lösung dieser Aufgabe sind elektronische Vorrichtungen entsprechend dem Patentanspruch 1 ausgebildet.

Durch die erfindungsgemäße Ausführung wird nicht nur einer optimalen Kühlung von Leistungsbauelementen bei elektronischen Vorrichtungen, Schaltkreisen oder Modulen, sondern auch der Erhöhung der Zuverlässigkeit und Lebensdauer solcher Vorrichtungen Rechnung getragen, und zwar dadurch, dass durch die besondere Ausbildung des wenigstens einen, das Leistungsbauelement tragenden ersten Metallisierungsbereichs dieser als ein die Kühlwirkung optimierender Wärmespreizer wirkt, zugleich aber das Volumen des metallischen Materials an diesem Metallisierungsbereich soweit reduziert wird, dass Temperaturwechsel, die während des Betriebes einer Vorrichtung, beispielsweise beim Schalten von Lasten auftreten, nicht zu einer Zerstörung des Substrates und/oder der Bauelemente durch thermisch bedingte mechanische Kräfte führt. Weiterbildungen der Erfindung sind Gegenstand der Unteransprüche.

Die Erfindung wird im Folgenden anhand der Figuren an Ausführungsbeispielen näher erläutert. Es zeigen:
- **Fig. 1**: in vereinfachter Darstellung und in Seitenansicht eine elektronische Vorrichtung (Schaltkreis oder Modul) gemäß der Erfindung;
- **Fig. 2**: eine vergrößerte Darstellung eines Teils der Vorrichtung der Figur 1 ;
- **Fig. 3 - 5**: jeweils die Verfahrensschritte unterschiedlicher Verfahren zum Herstellen desMetall-Isolierschicht-Substrates der Vorrichtung der Figuren 1 und 2.

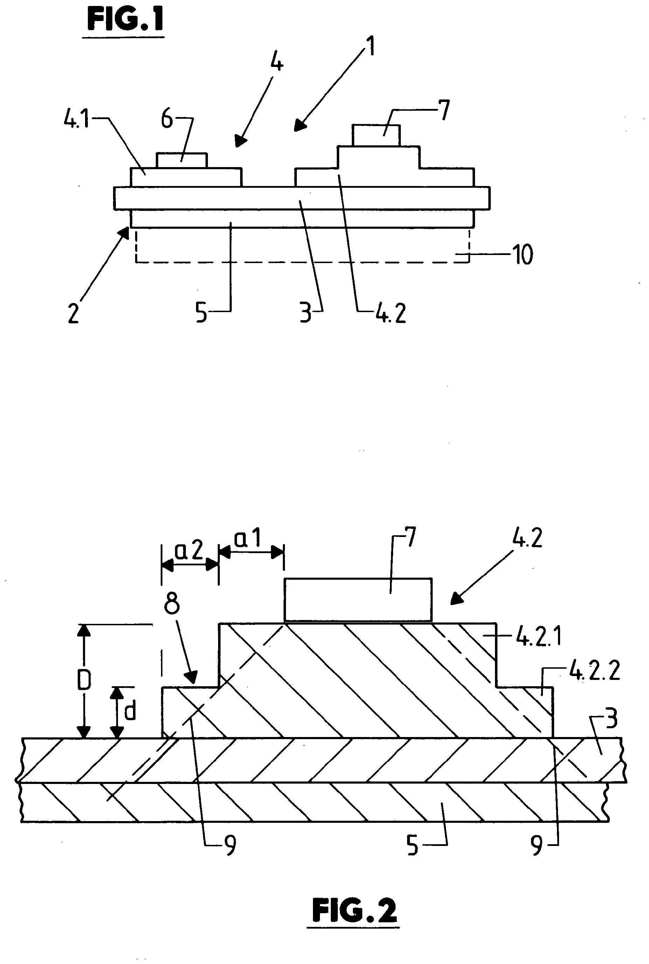

Die in den Figuren allgemein mit 1 bezeichnete elektronische Vorrichtung besteht bei der dargestellten Ausführungsform im Wesentlichen aus einem Metall-Isolierschicht- Substrat 2 mit einer bevorzugt keramischen Isolierschicht 3, auf deren Oberflächenseite jeweils eine Metallisierung 4 bzw. 5 vorgesehen ist. Zur Bildung einer Leiterplatte bzw. zur Bildung von Kontaktflächen und Leiterbahnen ist die obere Metallisierung 4 strukturiert, wie dies in der Figur 1 mit den beiden Metallisierungsbereichen 4.1 und 4.2 angedeutet ist. Die untere Metallisierung 5 ist durchgehend ausgebildet, d.h. sie erstreckt sich bis auf einen freien Randbereich über die gesamte untere Oberflächenseite der Isolierschicht 3. Geeignete Keramiken für die Isolierschicht 3 bestehen beispielsweise aus Aluminiumoxid (Al2O3), Aluminiumnitrid (AlN), Siliziumnitrid (Si3N4) und/oder Siliziumcarbid (SiC) oder aus Aluminiumoxid und Zirkonoxid (Al2O3 + ZrO2). Die Dicke der Isolierschicht 3 liegt in der Größenordnung zwischen etwa 0,15 mm und 1 mm.

Geeignete Materialien für die Metallisierungen 4 und 5 bzw. für die Metallisierungsbereiche 4.1 und 4.2 der Metallisierung 4 sind beispielsweise Kupfer, Kupferlegierungen oder Aluminium, Aluminiumlegierungen. Mit der Isolierschicht 3 sind die Metallisierungen 4 und 5 bzw. erfindungsgemäß die Metallisierungsbereiche 4.1 und 4.2 durch DCB-Bonden verbunden.

Auf den Metallisierungsbereichen 4.1 und 4.2 sind elektronische Bauelemente 6 bzw. 7 durch Löten, Kleben, Sintern oder auf andere geeignete Weise befestigt, und zwar derart, dass insbesondere auch eine thermische Verbindung zwischen dem Bauelement 6 und dem Metallisierungsbereich 4.1 sowie zwischen dem Bauelement 7 und dem Metallisierungsbereich 4.2 besteht. Das Bauelement 7 ist dabei ein Leistungsbauelement, beispielsweise ein Leistungshalbleiter-Bauelement oder -Chip (IC), z.B. Transistor, Diode, Triac Tyristor usw. mit erhöhter Verlustleistung und mit erhöhtem Kühlbedarf, während das Bauelement 6 ein solches geringer Leistung und damit auch geringer Verlustleistung ist, beispielsweise ein Halbleiter-Schaltkreis oder - Chip (IC) zum Ansteuern des Bauelementes 7.

Eine Besonderheit der Vorrichtung 1 bzw. des Metall-Isolierschicht-Substrates 2 besteht darin, dass erfindungsgemäß die strukturierte Metallisierung 4 im Wesentlichen nur in einem Teilbereich 4.2.1 unterhalb des jeweiligen Leistungs-Bauelementes 7, d. h. bei der dargestellten Ausführungsform unterhalb des Bauelementes 7 eine vergrößerte Schichtdicke D aufweist, ansonsten die Schichtdicke d der Metallisierung 4 und deren Metallisierungsbereiche 4.1 und 4.2, auch des Teilbereichs 4.2.2 deutlich reduziert und erfindungsgemäß etwa gleich der Schichtdicke d der unteren Metallisierung 5 ist. Der Metallisierungsbereich 4.2 lässt sich also hinsichtlich seiner Formgebung so beschreiben, dass er erfindungsgemäß aus dem Teilbereich 4.2.1 mit der Schichtdicke D und aus dem diesen umgebenden Teil- oder Randbereich 4.2.2 mit geringerer Schichtdicke d besteht, wobei der Metallisierungsbereich 4.2 erfindungsgemäß einstückig bzw. monolithisch mit diesen Teilbereichen ausgeführt ist.

Durch den Teilbereich 4.2.1 mit der Schichtdicke D und durch den den Teilbereich 4.2.1 umgebenden Teilbereich 4.2.2 ist der Metallisierungsbereich 4.2 an seinem Rand 8 stufenförmig ausgeführt, zwar derart, dass das Bauelement 7 von dem Rand der obersten Stufe bzw. von dem Rand des Teilbereichs 4.2.1 einen Abstand a1 besitzt, der wenigstens gleich oder etwas größer ist als die Differenz b der Schichtdicken D und d, d.h. a1 ≥ b.

Weiterhin gilt, dass die Breite a2 der durch die abgestufte Rand 8 gebildeten Stufe wenigstens gleich der Schichtdicke d ist.

Durch diese Ausbildung oder Formgebung des Metallisierungsbereichs 4.2 ist gewährleistet, dass er in optimaler Weise als Wärmespreizer für eine optimale Kühlung des Bauelementes 7 wirken kann, wie dies in der Figur 2 mit den unterbrochenen Linien 9 angedeutet ist, die unter einem Winkel von 45° gegenüber der Ebene der Oberflächenseiten der Isolierschicht 3 oder des Metall-Isolierschicht-Substrates 2 verlaufen. Zugleich sind durch diese Ausgestaltung das Metallvolumen des Metallisierungsbereichs 4.2 und damit auch die durch Temperaturwechsel bedingten mechanischen Spannungen zwischen der Metallisierung 4 bzw. dem Metallisierungsbereich 4.2 und der Isolierschicht 3 auf einen die Lebensdauer der Vorrichtung 1 nicht beeinträchtigenden Wert eingestellt.

Im Übrigen gilt für die Schichtdicken d und D, dass die Schichtdicke insbesondere der Metallisierung 4 außerhalb des Leistungsbauelementes 7 so gewählt ist, dass für die durch die Strukturierung der Metallisierung 4 erzeugten Leiterbahnen bzw. für die zu erwartenden Ströme ein ausreichend großer Querschnitt erzielt ist, während die Schichtdicke D der Metallisierung 4 unterhalb des Leistungsbauelementes 7 für eine optimale Kühlung und dabei insbesondere für eine optimale Wärmespreizung genügend groß gewählt ist. Hierfür sind die Schichtdicken D und d so gewählt, dass deren Differenz b gleich oder größer d/2 ist. Weiterhin gilt die Beziehung, dass die Summe der Abstände a1 und a2 wenigstens gleich, bevorzugt aber größer ist als die Schichtdicke D, die der Metallisierungsbereich 4.2 unter dem Bauelement 7 aufweist, also a1 + a2 > D.

Die Schichtdicken d der Metallisierung 4 außerhalb des Teilbereichs 4.2.1 und der Metallisierung 5 liegt beispielsweise in der Größenordnung zwischen 0,05 mm und 0,8 mm, die Schichtdicke D liegt dann z.B. in der Größenordnung zwischen 0,1 mm und 1,6mm.

Um das Metallvolumen des Metallisierungsbereichs 4.2 möglichst klein zu halten, beträgt das Flächenmaß der Fläche unter dem Bauelement 7 etwa 5mm² bis 180mm², vorzugsweise 9mm² bis 150mm², was für die Anordnung üblicher Halbleiterbauelemente, wie Leistungstransistoren und Dioden ausreichend ist, insbesondere auch für solche Halbleiterbauelemente, die als integrierter Halbleiterschaltkreise aus einem Steuer- oder Schaltelement und einer Diode bestehen.

Über die Metallisierung 5 ist die Vorrichtung 1 zumindest thermisch mit einem Kühler oder einer Wärmesenke verbunden, wie dies in der Figur 1 mit der unterbrochenen Linie angedeutet ist. Der Kühler 10 ist beispielsweise ein passiver Kühler, der über Kühlflächen, beispielsweise in Form von Kühlrippen die Verlustwärme an die Umgebung, beispielsweise an die umgebende Luft weiterleitet, oder aber ein aktiver Kühler, der wenigstens einen von einem Kühlmedium, beispielsweise von einem flüssigen Kühlmedium durchströmbaren Kühlkanal gebildet.

Die Verbindung zwischen der Metallisierung 5 und dem Kühler 10 ist beispielsweise durch Kleben, Sintern, Löten, DCB-Bonden realisiert. Grundsätzlich besteht auch die Möglichkeit, unter Verzicht auf die Metallisierung 5 den Kühler 10 direkt an der der Metallisierung 4 abgewandten Unterseite der Isolierschicht 3 vorzusehen, und zwar wiederum durch DCB-Bonden, Aktivlöten, Kleben usw.

Die beschriebene Ausbildung des Metall-Isolierschicht-Substrates 2 hat weiterhin auch den Vorteil, dass durch die reduzierte Schichtdicke der Metallisierung 4 außerhalb des Teilbereichs 4.2.1 eine feine Strukturierung insbesondere des Metallisierungsbereichs 4.1 ermöglicht, und zwar zur Bildung von fein strukturierten Leiterbahnen, Kontaktflächen usw. Hiermit besteht insbesondere auch die Möglichkeit, komplexe Schaltungen, die eine Vielzahl von Bauelementen, insbesondere auch von aktiven Bauelementen aufweisen, zusammen mit wenigstens einem Leistungsbauelement kompakt, d.h. auf einem Metall-Isolierschicht-Substrat 2 mit kleinen Abmessungen zu realisieren. Durch die geringe Schichtdicke der Metallisierungen 4 und 5 und insbesondere auch durch die Reduzierung des Metallvolumens des Metallisierungsbereichs 4.2 wird weiterhin auch ein Verbiegen des Metall- Isolierschicht-Substrats beim Erwärmen aufgrund des Bimetalleffektes vermieden, zumindest aber soweit vermieden, dass eine Schädigung der Bauelemente 6 und 7 nicht eintritt.

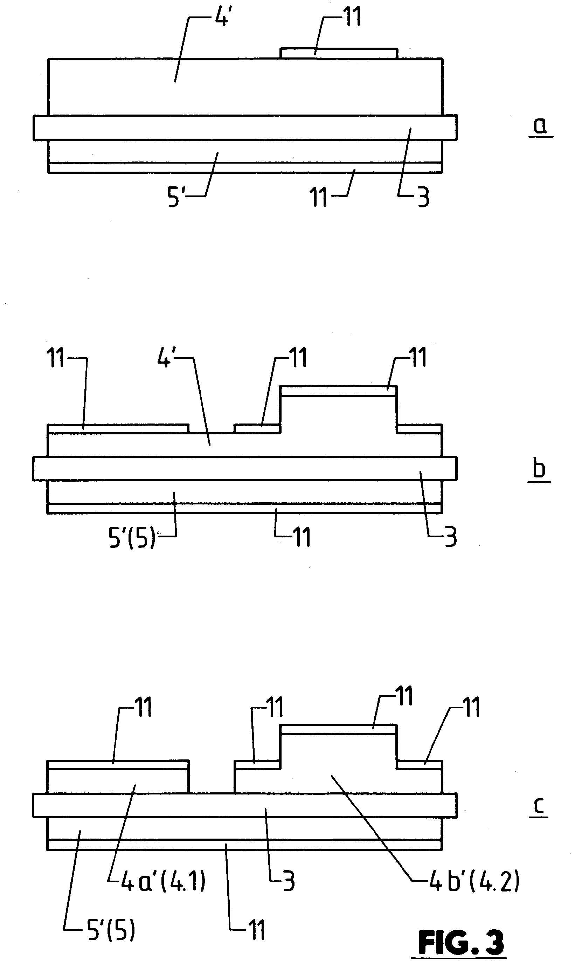

Die Figur 3 zeigt in den Positionen a) - c) die Schritte eines Herstellungsverfahrens zum Herstellen des Metall-Isolierschicht-Substrates 2. Bei diesem Verfahren werden zunächst auf die Oberseite der Isolierschicht 3 eine Metallschicht in Form einer Metallfolie 4' (z.B. Kupfer- oder Aluminiumfolie) mit der Schichtdicke D und auf die Unterseite der Isolierschicht 3 eine Metallschicht in Form einer Metallfolie 5'(z.B. Kupfer- oder Aluminiumfolie) mit der Schichtdicke d aufgebracht. Die Metallfolie 4' wird dort, wo die Metallisierung 4 des fertigen Substrates 2 die Schichtdicke D aufweisen soll, mit einem Lack oder Photolack bzw. Ätzresist 1 1 maskiert (Position a))

Im Anschluss erfolgt ein Abätzen der Metallfolie 4', bis diese dann entsprechend der Position b) außerhalb des Ätzresists 11 die Schichtdicke d aufweist.

Anschließend wird die gesamte Oberfläche der verbliebenen Metallfolie 4' mit dem Ätzresist 1 1 abgedeckt, und zwar bis auf diejenigen Bereiche, an denen die Metallisierung 4 nicht vorgesehen ist, d.h. u.a. bis auf die Zwischenräume zwischen den Metallisierungsbereichen 4.1 und 4.2, sodass nach einem nochmaligen Ätzen und Entfernen des Ätzresists 1 1 die Strukturierung der Metallisierung 4 erreicht ist (Position c)).

Die die Metallisierung 5 bildende Metallfolie 5' mit der Schichtdicke d ist während des gesamten Strukturierungsprozesses beispielsweise durch Abdecken mit dem Ätzresists 1 1 oder auf andere geeignete Weise geschützt.

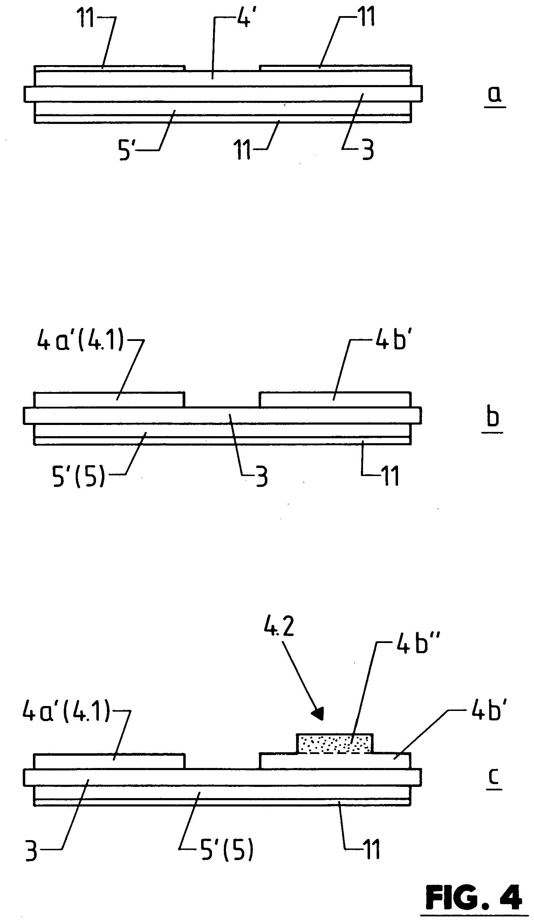

Die Figur 4 zeigt in den Positionen a) - c) die Schritte eines Herstellungsverfahrens, bei dem zunächst auf beide Oberflächenseiten der Isolierschicht 3 Metallschichten in Form von Metallfolien 4' und 5'(z.B. Kupfer- oder Aluminiumfolie) mit der Schichtdicke d aufgebracht werden (Position a)).

Durch Aufbringen eines Ätzresists 1 1 und durch einschließendes Ätzen wird die Metallfolie 4' in den Folienbereich 4a', der den Metallisierungsbereich 4.1 bildet, und in den Folienbereich 4b' strukturiert. Auf dem Folienbereich 4b' wird dann in einem geeigneten Verfahren, beispielsweise durch galvanisches und/oder chemisches Abscheiden und/oder durch thermisches Spritzen und/oder in einem Plasmaverfahren eine zusätzliche Metallschicht 4b" aufgebracht, und zwar so, dass mit dem Folienbereich 4b' und der zusätzlichen Metallschicht 4b"die für den Metallisierungsbereich 4.2 erforderliche Formgebung erreicht wird.

Das Metall der zusätzlichen Metallschicht 4b" ist beispielsweise das Metall der Metallfolie 4', z.B. Kupfer, Kupferlegierung, Aluminium oder Aluminiumlegierung. Grundsätzlich kann für die zusätzliche Metallschicht 4b" auch ein von der Metallfolie 4' unterschiedliches Metall verwendet sein. Weiterhin kann die zusätzliche Metallschicht 4b" auch durch Lasersintern unter Verwendung eines metallischen Sintermaterials als Sinterschicht erzeugt werden.

Die die Metallisierung 5 bildende Metallfolie 5' ist wiederum während des gesamten Prozesses geschützt, beispielsweise durch Abdecken mit einer Schutzschicht oder auf andere Weise.

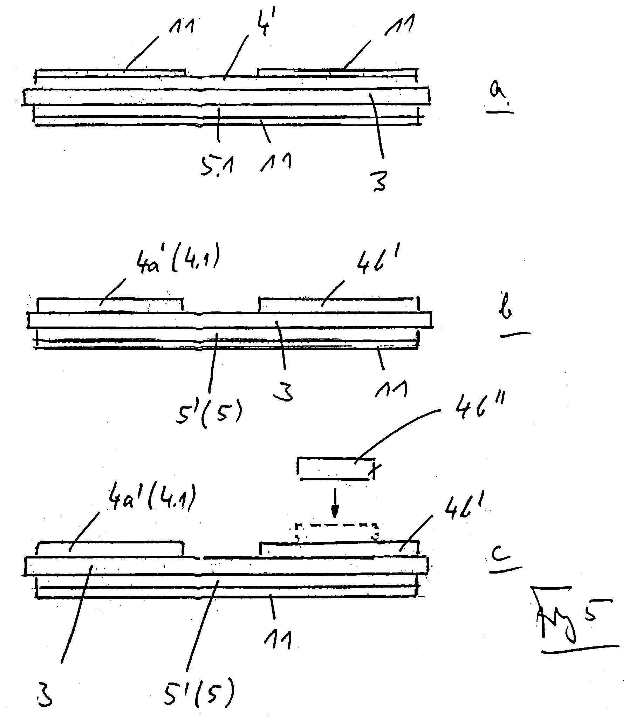

Die Figur 5 zeigt in den Positionen a) - c) die Schritte eines Herstellungsverfahrens, bei dem zunächst auf beide Oberflächenseiten der Isolierschicht 3 Metallschichten in Form von Metallfolien 4' und 5'(z.B. Kupfer- oder Aluminiumfolie) mit der Schichtdicke d aufgebracht werden. Die Metallfolie 4 wird anschließend in die Folienbereiche 4a' und 4b' strukturiert, z.B. durch Maskieren und Ätzen (Positionen a) und b)).

Auf den Folienbereich 4b' wird die zusätzliche Metallschicht 4b" in Form eines Metallplättchens aufgebracht, welches beispielsweise durch DIRECT-Bonden oder DCB- Bonden, durch Löten, vorzugsweise durch Hartlöten mit der Metallschicht 4b' verbunden wird und so zusammen mit dem Folienbereich 4b' den Teilbereich 4.2.1 bildet. Das Aufbringen des die Metallschicht 4b" bildenden Metallplättchen erfolgt insbesondere dann, wenn das Metall-Isolierschicht-Substrat zusammen mit einer Vielzahl weiterer Substrate unter Verwendung einer großformatigen Keramikplatte im Mehrfachnutzen hergestellt wird, unter Verwendung einer Maske aufgebracht und/oder in das die weitere Metallschicht 4b" bildende Plättchen ist Bestandteil eines beispielsweise durch Stanzen aus einer Metallfolie hergestellten Formteils, in welchem das jeweilige Plättchen über wenigstens einen Steg gehalten ist, der dann nach dem Verbinden des Plättchens mit der Metallschicht 4b' beispielsweise mechanisch oder aber auf andere geeignete Weise, z.B. durch Lasern abgetrennt wird.

Vorstehend wurde der einfacheren Darstellung wegen davon ausgegangen, dass die Metallisierung 4 lediglich zwei Metallisierungsbereiche 4.1 und 4.2 bildet. In der praktischen Ausführung der Vorrichtung 1 kann diese selbstverständlich auch mehrere Metallisierungsbereiche 4.1 geringerer Schichtdicke sowie insbesondere auch mehrere Metallisierungsbereiche 4.2 für mehrere Leistungsbauelemente 7 aufweisen. Weiterhin besteht die Möglichkeit, dass die elektronische Vorrichtung bzw. deren Metall- Isolierschicht-Substrat lediglich einen oder aber mehrere Metallisierungsbereiche 4.2 besitzt.

Die Erfindung wurde voranstehend aus Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird. Vorstehend wurde davon ausgegangen, dass lediglich die Metallisierung 4 strukturiert ist. Selbstverständlich sind auch Ausführungen möglich, bei denen die Metallisierung 5 ebenfalls strukturiert ist.

### Bezugszeichenliste:

- 1: elektronische Vorrichtung oder Schaltkreis
- 2: Metall-Isolierschicht-Substrat
- 3: Isolierschicht
- 4, 5: Metallisierung
- 4.1 , 4.2: Metallisierungsbereich
- 4': Metallschicht oder Metallfolie
- 4b', 4b": Metallschicht
- 5: Metallisierung
- 6, 7: Bauelement
- 8: Stufe
- 9: Linie
- 10: Kühler
- 11: Schutzschicht oder Ätzresists
- A: Abstand zwischen Bauelement 7 und obersten Rand des Metallisierungsbereichs 4.2
- a2: Breite der Stufe 8
- d: Schichtdicke der Metallisierungen 4 und 5 außerhalb des Bauelement 7 aufweisenden Teilbereichs 4.2.1
- D: Schichtdicke der Metallisierung 4 unterhalb des Bauelementes 7 b Differenz der Schichtdicken D und d

## Patentansprüche

1. Elektronische Vorrichtung, insbesondere elektronischer Schaltkreis oder elektronisches Modul, mit wenigstens einem zumindest aus einer Isolierschicht (3) und wenigstens einer ersten Metallisierung (4) an einer Oberflächenseite der Isolierschicht (3) bestehenden Metall-Isolierschicht-Substrat (2), dessen erste Metallisierung (4) zur Bildung von Metallisierungsbereichen (4.1,4.2) strukturiert ist, wobei die Metallisierungsbereiche über ein DCB-Bonden mit der Isolierschicht (3) verbunden sind, sowie mit wenigstens einem Verlustwärme erzeugenden elektrischen oder elektronischen Bauelement (7) an einem ersten Metallisierungsbereich (4.2) der ersten Metallisierung (4), wobei der erste Metallisierungsbereich (4.2) aus einem Teilbereich (4.2.1) mit einer Schichtdicke D, mit welchem das Bauelement (7) zumindest thermisch verbunden ist, und einem den Teilbereich mit der Schichtdicke D zumindest teilweise umgebenden Teilbereich mit einer geringeren Schichtdicke d besteht, wobei der erste Metallisierungsbereich einstückig mit diesen Teilbereichen ausgeführt ist, , wobei die Differenz (b) der Schichtdicken (D, d) wenigstens gleich oder größer ist als die halbe Schichtdicke (d), die der erste Metallisierungsbereich (4.2) außerhalb des Teilbereichs (4.2.1) mit der Schichtdicke D aufweist, und dass der Abstand (a1), den das Bauelement (7) vom Rand des Teilbereichs (4.2.1) mit der Schichtdicke D besitzt, gleich oder größer als die Differenz (b) der Schichtdicken (D, d) ist, wobei die erste Metallisierung (4) zusätzlich zu dem wenigstens einen ersten Metallisierungsbereich (4.2) wenigstens einen zweiten strukturierten Metallisierungsbereich (4.1) aufweist, dessen Schichtdicke kleiner ist als die Schichtdicke (D) des Teilbereichs (4.2.1) mit der Schichtdicke D oder dessen Schichtdicke gleich der Schichtdicke (d) ist, die der wenigstens eine erste Metallisierungsbereich (4.2.1) außerhalb des Teilbereichs (4.2.1) mit der Schichtdicke D besitzt, wobei die strukturierte erste Metallisierung (4) nur unterhalb des jeweiligen Leistungs-Bauelements (7) und in einem Abstand a1 um das Leistungs-Bauelements (7) einen Teilbereich mit der Schichtdicke D aufweist, wobei eine untere Metallisierung (5) eine Schichtdicke aufweist, die im Wesentlichen der Schichtdicke (d) im Teilbereich mit der Schichtdicke d entspricht.

2. Vorrichtung nach Anspruch 1, **dadurch gekennzeichnet, dass** auf der der ersten Metallisierung (4) abgewandten Oberflächenseite der Isolierschicht (3) eine zweite Metallisierung (5) vorzugsweise eine durchgehende, d.h. nicht strukturierte zweite Metallisierung (5) vorgesehen ist.

3. Vorrichtung nach einem der vorhergehenden Ansprüche, **dadurch gekennzeichnet, dass** die Schichtdicke der zweiten Metallisierung (5) 0,5 mm bis 0,8 mm beträgt.

4. Vorrichtung nach einem der vorhergehenden Ansprüche, **dadurch gekennzeichnet, dass** die Dicke der Isolierschicht (3) 0,15 mm bis 1,0 mm beträgt.

5. Vorrichtung nach einem der vorhergehenden Ansprüche, **dadurch gekennzeichnet, dass** die Isolierschicht eine Keramikschicht ist, vorzugsweise eine Keramikschicht aus Al₂O₃, AlN, Si₃N₄, SiC oder Al₂O₃ + ZrO₂.

6. Vorrichtung nach einem der vorhergehenden Ansprüche, **dadurch gekennzeichnet, dass** die von dem Bauelement (7) eingenommene Fläche ein Flächenmaß von 5 mm² - 180 mm², vorzugsweise ein Flächenmaß von 9 mm² bis 150 mm² aufweist.

7. Vorrichtung nach einem der vorhergehenden Ansprüche, **dadurch gekennzeichnet, dass** die erste und/oder zweite Metallisierung aus Kupfer, aus einer Kupferlegierung, aus Aluminium oder einer Aluminiumlegierung besteht.

8. Vorrichtung nach einem der vorhergehenden Ansprüche, **dadurch gekennzeichnet, dass** das Verlustwärme erzeugende Bauelement (7) über eine Lot- oder Sinter- oder Klebeverbindung mit dem ersten Metallisierungsbereich (4.2) der ersten Metallisierung (4) verbunden ist.

9. Vorrichtung nach einem der vorhergehenden Ansprüche, **dadurch gekennzeichnet, dass** die Isolierschicht beispielsweise über die zweite Metallisierung (5) mit einem Kühler (10) verbunden ist, beispielsweise durch DCB-Bonden, Löten, auch Aktivlöten.

10. Vorrichtung nach einem der vorhergehenden Ansprüche, **dadurch gekennzeichnet, dass** die Metallisierungsbereiche (4.1, 4.2) der ersten Metallisierung (4) durch Stufenätzen erzeugt sind.

11. Vorrichtung nach einem der vorhergehenden Ansprüche, **dadurch gekennzeichnet, dass** wenigstens ein zweiter Metallisierungsbereich (4.1) zur Bildung von Leiterbahnen und/oder Kontaktflächen strukturiert ist.

12. Vorrichtung nach einem der vorhergehenden Ansprüche, **dadurch gekennzeichnet, dass** auf wenigstens einem zweiten Metallisierungsbereich (4.1), vorzugsweise auf wenigstens einem strukturierten Metallisierungsbereich (4.1) ein Bauelement (6) mit reduzierter Verlustleistung vorgesehen ist.

## Claims

1. An electronic device, in particular electronic circuit or electronic module, having at least one metal insulating layer substrate (2) consisting of at least one insulating layer (3) and at least one first metallization (4) on a surface side of the insulating layer (3), the first metallization (4) of which is structured to form metal regions (4.1, 4.2), the metal regions being connected to the insulating layer (3) by means of DCB bonding, and having at least one electrical or electronic component (7) generating heat loss at a first metal region (4.2) of the first metallization (4), the first metal region (4.2) consisting of a sub-region (4.2.1) having a layer thickness D, to which the component (7) is at least thermally connected, and a sub-region having a smaller layer thickness d, which at least partially surrounds the sub-region having the layer thickness D, the first metal region being formed in one piece and including these subregions, the difference (b) in the layer thicknesses (D, d) being at least equal to or greater than half the layer thickness (d) which the first metal region (4.2) has outside the sub-region (4.2.1) having the layer thickness D, the distance (a1), which the component (7) has from an edge of the sub-region (4.2.1) having the layer thickness D, being equal to or greater than the difference (b) in the layer thicknesses (D, d), wherein in addition to the at least one first metal region (4.2) the first metallization (4) has at least one second structured metal region (4.1) whose layer thickness is smaller than the layer thickness (D) of the sub-region (4.2.1) having the layer thickness D or whose layer thickness is equal to the layer thickness (d) which the at least one first metal region (4.2.1) has outside the sub-region (4.2.1) having the layer thickness D, wherein the structured first metallization (4) forms a sub-region having the layer thickness D only below the respective power component (7) and at a distance a1 around the power component (7), wherein a lower metallization (5) has a layer thickness which substantially corresponds to the layer thickness (d) in the sub-region having the layer thickness d.

2. The device according to claim 1, **characterised in that** a second metallization (5), preferably a continuous, i.e. non-structured second metallization (5), is provided on the surface side of the insulating layer (3) facing away from the first metallization (4).

3. The device according to one of the preceding claims, **characterized in that** the layer thickness of the second metallization (5) is 0.5 mm to 0.8 mm.

4. The device according to any of the preceding claims, **characterized in that** the thickness of the insulating layer (3) is 0.15 mm to 1.0 mm.

5. The device according to any of the preceding claims, **characterized in that** the insulating layer is a ceramic layer, preferably a ceramic layer of Al₂O₃, AlN, Si₃N₄, SiC or Al₂O₃ + ZrO₂.

6. The device according to one of the preceding claims, **characterized in that** the surface area occupied by the structural element (7) has a surface area of 5 mm² - 180 mm², preferably a surface area of 9 mm² to 150 mm².

7. The device according to any of the preceding claims, **characterized in that** the first and/or second metallization is made of copper, of a copper alloy, of aluminium or of an aluminium alloy.

8. The device according to one of the preceding claims, **characterized in that** the heat loss generating component (7) is connected to the first metal region (4.2) of the first metallization (4) via a solder or sinter or adhesive joint.

9. The device according to one of the preceding claims, **characterized in that** the insulating layer is connected to a cooler (10), for example via the second metallization (5), for example by DCB bonding, soldering, also active soldering.

10. The device according to one of the preceding claims, **characterised in that** the metallisation areas (4.1, 4.2) of the first metallisation (4) are formed by step etching.

11. The device according to one of the preceding claims, **characterized in that** at least a second metallization area (4.1) is structured to form conductor tracks and/or contact surfaces.

12. The device according to one of the preceding claims, **characterised in that** a component (6) with reduced power loss is located on at least one second metal region (4.1), preferably on at least one structured metal region (4.1).

## Revendications

1. Dispositif électronique, en particulier circuit électronique ou module électronique, comportant au moins un substrat composite métal/couche isolante (2) constitué d'au moins une couche isolante (3) et d'au moins une première métallisation (4) sur un côté de la surface de la couche isolante (3), dont la première métallisation (4) est structurée pour former des zones de métallisation (4.1, 4.2), les zones de métallisation étant reliées à la couche isolante (3) par collage (« bonding ») DCB, et comportant au moins un composant (7) électrique ou électronique générant de la chaleur dissipée sur une première zone de métallisation (4.2) de la première métallisation (4),
dans lequel la première zone de métallisation (4.2) est constituée par une zone partielle (4.2.1) ayant une épaisseur de D et à laquelle le composant (7) est relié au moins thermiquement, et une zone partielle ayant une épaisseur de couche d inférieure entourant au moins partiellement la zone partielle ayant l'épaisseur de couche D,
la première zone de métallisation est réalisée d'un seul tenant avec ces zones partielles,
la différence (b) des épaisseurs de couche (D, d) est au moins égale ou supérieure à la moitié de l'épaisseur de couche (d) que présente la première zone de métallisation (4.2) à l'extérieur de la zone partielle (4.2.1) ayant l'épaisseur de couche D, et
la distance (a1) que présente le composant (7) par rapport au bord de la zone partielle (4.2.1) ayant l'épaisseur de couche D est égale ou supérieure à la différence (b) des épaisseurs de couche (D, d),
la première métallisation (4) présente, en supplément à ladite au moins une première zone de métallisation (4.2), au moins une seconde zone de métallisation structurée (4.1) dont l'épaisseur de couche est inférieure à l'épaisseur de couche (D) de la zone partielle (4.2.1) ayant l'épaisseur de couche D, ou dont l'épaisseur de couche est égale à l'épaisseur de couche (d) que présente la première zone de métallisation (4.2.1) à l'extérieur de la zone partielle (4.2.1) ayant l'épaisseur de couche D, et
la première métallisation structurée (4) présente une zone partielle ayant l'épaisseur de couche D uniquement au-dessous du composant de puissance respectif (7) et à une distance a1 autour du composant de puissance (7),
une métallisation inférieure (5) présente une épaisseur de couche qui correspond sensiblement à l'épaisseur de couche (d) dans la zone partielle ayant l'épaisseur de couche d.

2. Dispositif selon la revendication 1,
**caractérisé en ce que**
sur le côté de surface de la couche isolante (3) détourné de la première métallisation (4), il est prévu une seconde métallisation (5), de préférence une seconde métallisation (5) continue, c'est-à-dire non structurée.

3. Dispositif selon l'une des revendications précédentes,
**caractérisé en ce que**
l'épaisseur de couche de la seconde métallisation (5) est de 0,5 mm à 0,8 mm.

4. Dispositif selon l'une des revendications précédentes,
**caractérisé en ce que**
l'épaisseur de la couche isolante (3) est comprise entre 0,15 mm et 1,0 mm.

5. Dispositif selon l'une des revendications précédentes,
**caractérisé en ce que**
la couche isolante est une couche céramique, de préférence une couche céramique en Al₂O₃, AlN, Si₃N₄, SiC ou Al₂O₃ + ZrO₂.

6. Dispositif selon l'une des revendications précédentes,
**caractérisé en ce que**
la surface occupée par le composant (7) présente une dimension de surface de 5 mm² à 180 mm², de préférence une dimension de surface de 9 mm² à 150 mm².

7. Dispositif selon l'une des revendications précédentes,
**caractérisé en ce que**
la première et/ou la seconde métallisation est constituée de cuivre, d'un alliage de cuivre, d'aluminium ou d'un alliage d'aluminium.

8. Dispositif selon l'une des revendications précédentes,
**caractérisé en ce que**
le composant (7) générant la chaleur dissipée est relié à la première zone de métallisation (4.2) de la première métallisation (4) au moyen d'une liaison soudée ou frittée ou adhésive.

9. Dispositif selon l'une des revendications précédentes,
**caractérisé en ce que**
la couche isolante est reliée à un refroidisseur (10), par exemple par la seconde métallisation (5), par exemple par collage (« bonding») DCB, par brasage ou par brasage actif.

10. Dispositif selon l'une des revendications précédentes,
**caractérisé en ce que**
les zones de métallisation (4.1, 4.2) de la première métallisation (4) sont réalisées par gravure par étapes.

11. Dispositif selon l'une des revendications précédentes,
**caractérisé en ce que**
au moins une seconde zone de métallisation (4.1) est structurée pour former des pistes conductrices et/ou des surfaces de contact.

12. Dispositif selon l'une des revendications précédentes,
**caractérisé en ce que**
un composant (6) à perte de puissance réduite est prévu sur au moins une seconde zone de métallisation (4.1), de préférence sur au moins une zone de métallisation structurée (4.1).
